# EUROPEAN PATENT APPLICATION

(11) **EP 4 614 168 A1**
(43) Date of publication of application: **10.09.2025**
(21) Application number: 24214809.6
(22) Date of filing: 22.11.2024
(51) Int. Cl.: G01R 31/389

(54) **APPARATUS AND METHOD FOR CALCULATING INTERNAL RESISTANCE OF BATTERY**

(30) Priority: 05.03.2024 KR 20240031334
(71) Applicant: SAMSUNG SDI CO., LTD., Yongin-si, Gyeonggi-do 17084 (KR)
(72) Inventor: OH, Byoung Gul, 16678 Suwon-si (KR); KANG, Kyoung Min, 16678 Suwon-si (KR); OH, Young Kyu, 16678 Suwon-si (KR); LEE, Jong Chul, 16678 Suwon-si (KR)
(74) Representative: Marks & Clerk LLP

(57) **Abstract**

The present disclosure relates to an apparatus and method for calculating an internal resistance of a battery, and a computer program. The technical solution is to provide a topology capable of measuring an internal resistance of a battery cell even when the battery is mounted on a vehicle without the separation or removal of the battery from the vehicle. To this end, the present disclosure provides a configuration for calculating an internal resistance of a battery based on a current parameter and a voltage parameter of the battery when a data collection condition, which is predefined based on the discharge current characteristics of the battery in a driving state of a vehicle, is satisfied.

## Description

### BACKGROUND

### 1. Field

The present disclosure relates to an apparatus and method for calculating an internal resistance (direct current internal resistance (DCIR)) of a battery, and a computer program.

### 2. Description of the Related Art

A battery pack is manufactured through a method in which single cells are welded and accommodated in a housing to assemble modules, and then the modules are connected through busbars and wires. Since a process of storing (charging) and consuming (discharging) electrical energy is repeated, it is very important to secure data on resistance values which are directly related to the lifespan. In particular, in order to predict and manage the lifespan due to repeated charging or discharging of a battery pack mounted on an electric vehicle, it is necessary to accurately and easily calculate the internal resistance (direct current internal resistance (DCIR)) of a battery cell.

Generally, the internal resistance of a battery cell is calculated based on an amount of voltage drop measured in a process of discharging a step current through a charger/discharger. A method of measuring an internal resistance of a battery cell mounted on an electric vehicle is not standardized, but generally, a method of discharging a battery cell for a certain time (10 seconds) through a charger/discharger and calculating an internal resistance through a voltage drop thereof is applied.

However, such a method is based on the internal resistance of a battery cell being measured in a state in which the battery cell is separated from a vehicle, and since the battery cell cannot be separated in a driving state of the vehicle, there are temporal and spatial limitations in measuring the internal resistance of the battery cell.

The above information disclosed in this Background section is for enhancement of understanding of the background of the present disclosure, and therefore, it may contain information that does not constitute related (or prior) art.

### SUMMARY

The present disclosure is directed to providing an apparatus and method for calculating an internal resistance of a battery, and a computer program, in which, by measuring an internal resistance of a battery cell mounted on a vehicle in a driving state (actual driving state or driving simulation state) of the vehicle, without the separation or removal of the battery from the vehicle, the internal resistance of the battery cell can be measured even when the battery is mounted on the vehicle.

However, objects that the present disclosure intends to achieve are not limited to the above-described objects and other objects that are not described may be clearly understood by those skilled in the art from the following description.

According to an aspect of the present disclosure, there is an apparatus for calculating an internal resistance of a battery, the apparatus including a processor configured to calculate an internal resistance of a battery mounted on a vehicle, and a memory configured to store instructions executed by the processor, wherein, when a data collection condition, which is predefined based on discharge current characteristics of the battery in a driving state of the vehicle, is satisfied, the processor collects a current parameter and a voltage parameter of the battery and calculates the internal resistance of the battery based on the collected current parameter and voltage parameter.

At least some of the above and other features of the invention are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 illustrates a prismatic battery according to one embodiment of the present disclosure;
FIG. 2 is a cross-sectional view illustrating the prismatic battery according to one embodiment of the present disclosure;
FIG. 3 illustrates a battery module according to one embodiment of the present disclosure;
FIGS. 4A and 4B illustrate a battery pack according to one embodiment of the present disclosure;
FIGS. 5A and 5B illustrate a vehicle body and vehicle body parts according to one embodiment of the present disclosure;
FIG. 6 is a block diagram of an apparatus for calculating an internal resistance of a battery according to one embodiment of the present disclosure;
FIG. 7 shows an example of a data collection condition in an apparatus for calculating an internal resistance of a battery according to one embodiment of the present disclosure.
FIGS. 8 to 10 show a process for calculating an internal resistance in the apparatus for calculating an internal resistance of a battery according to one embodiment of the present disclosure; and
FIGS. 11 to 13 are a flowchart of a method of calculating an internal resistance of a battery according to one embodiment of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her disclosure in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of' and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Before a detailed description of the present embodiment, first, the structure of a battery of which an internal resistance is to be measured in the present embodiment will be briefly described.

### [Prismatic battery]

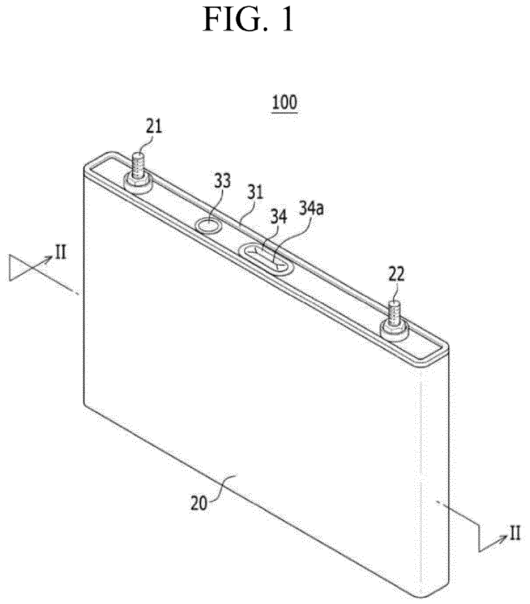

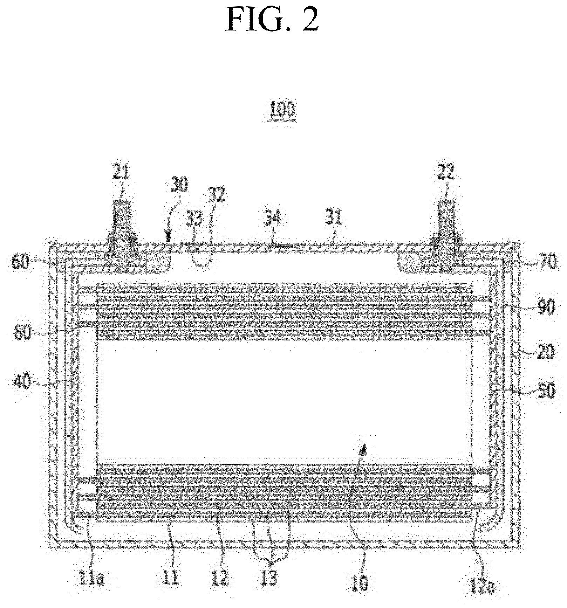

FIG. 1 is a perspective view illustrating a secondary battery applied to the present embodiment, and FIG. 2 is a cross-sectional view along line II-II in FIG. 1 (in FIGS. 1 and 2, the same reference symbols as other drawings may be shown, but usage of the reference symbols shown in FIGS. 1 and 2 is exclusive to FIGS. 1 and 2).

Referring to FIGS. 1 and 2, the secondary battery 100 according to one or more embodiments of the present disclosure may include at least one electrode assembly 10 wound with a separator 13 as an insulator between the positive electrode 11 and the negative electrode 12, a case 20 in which the electrode assembly 10 is received (or accommodated) therein, and a cap assembly 30 coupled to an opening of the case 20.

The secondary battery 100 according to one or more embodiments illustrated in FIGS. 1 and 2 will now be described as an example of a prismatic lithium ion secondary battery. However, the present disclosure is not limited thereto, and suitable aspects, features and principles described herein may be applied to various other types of batteries, such as lithium polymer batteries and/or cylindrical batteries.

Each of the positive electrode 11 and the negative electrode 12 may include a current collector made of a thin metal foil having a coated portion on which an active material is coated and an uncoated portion 11a, 12a on which an active material is not coated.

The positive electrode 11 and the negative electrode 12 are wound after interposing the separator 13, which is an insulator, therebetween. However, the present disclosure is not limited thereto, and the electrode assembly 10 may have a structure in which a positive electrode 11 and a negative electrode 12, each made of a plurality of sheets, are alternately stacked with a separator interposed therebetween.

The case 20 may form the overall outer appearance of the secondary battery 100 and may be made of a conductive metal, such as aluminum, aluminum alloy, or nickel-plated steel. In addition, the case 20 may provide a space in which the electrode assembly 10 is accommodated.

The cap assembly 30 may include a cap plate 31 covering an opening in the case 20, and the case 20 and the cap plate 31 may be made of a conductive material. The positive and negative electrode terminals 21 and 22 electrically connected to the positive electrode 11 and the negative electrode 12, respectively, may be installed to penetrate (or extend through) the cap plate 31 and protrude outwardly therethrough.

In addition, outer peripheral surfaces (e.g., circumferential surfaces) of upper pillars of the positive and negative electrode terminals 21 and 22 protruding outwardly from the cap plate 31 may be threaded and may be fixed to the cap plate 31 by utilizing nuts.

However, the present disclosure is not limited thereto, and the positive and negative electrode terminals 21 and 22 may have a rivet structure and may be riveted or welded to the cap plate 31.

In addition, the cap plate 31 may be made of a thin plate and may be coupled to the opening in the case 20, and an electrolyte injection port 32 into which a sealing stopper 33 may be installed may be located (e.g., formed) in the cap plate 31. A vent portion 34 having a notch 34a may also be installed in the cap plate 31.

The positive and negative electrode terminals 21 and 22 may be electrically connected to current collectors including first and second current collectors 40 and 50 (hereinafter referred to as positive and negative current collectors) by being bonded or coupled (e.g., by welding) to the positive uncoated portion 11a and the negative electrode uncoated portion 12a, respectively.

For example, the positive and negative electrode terminals 21 and 22 may be coupled by welding to the positive and negative electrode current collectors 40 and 50, respectively. However, the present disclosure is not limited thereto, and the positive and negative electrode terminals 21 and 22 and the positive and negative electrode current collectors 40 and 50 may be integrally formed in one or more embodiments.

In addition, an insulation member may be installed between the electrode assembly 10 and the cap plate 31. The insulation member may include first and second lower insulation members 60 and 70, and each of the first and second lower insulation members 60 and 70 may also have a portion located between the electrode assembly 10 and the case 20.

In addition, according to one or more embodiments of the present disclosure, one end of a separation member may face one side of the electrode assembly 10 and may be installed between the insulation member and the positive or negative electrode terminals 21 and 22.

In one or more embodiments, the separation member may include first and second separation members 80 and 90.

In such an embodiment, a first end of the first separation member 80installed to face one side of the electrode assembly 10 may be installed between the first lower insulation member 60 and the positive electrode terminal 21, and a first end of the second separation member 90 installed to face one side of the electrode assembly 10 may be installed between the second lower insulation member 70 and the positive electrode terminal 22.

Accordingly, the positive and negative electrode terminals 21 and 22, which may be coupled by welding to the positive and negative electrode current collectors 40 and 50, may be coupled to first ends of the first and second lower insulation members 60 and 70 and the first and second separation members 80 and 90.

### [Battery module]

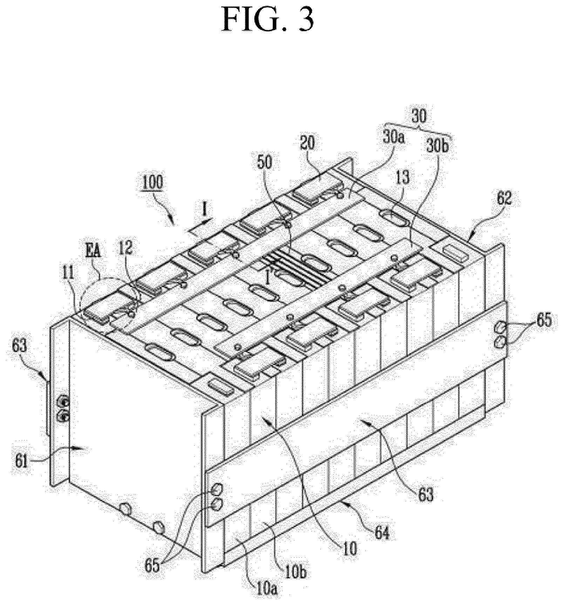

FIG. 3 is a perspective view illustrating a battery module according to one embodiment of the present disclosure (in FIG. 3, the same reference symbols as other drawings may be shown, but usage of the reference symbols shown in FIG. 3 is exclusive to FIG. 3).

Referring to FIG. 3, the battery module 100 according to one or more embodiments of the present disclosure includes electrode units 11 and 12, a plurality of battery cells 10 arranged in one direction, a connection tab 20 connecting a battery cell 10a to an adjacent battery cell 10b, and a protection circuit module 30 having one end connected to the connection tab 20. The protection circuit module 30 may include a battery management system (BMS). Further, the connection tab 20 may include a body portion in contact with the electrode units 11 and 12 between the adjacent battery cells 10a and 10b and an extension portion extending from the body portion and connected to the protection circuit module 30. The connection tab 20 may be, for example, a bus bar.

Each battery cell 10 may include a battery case, an electrode assembly received (or accommodated) in the battery case, and an electrolyte. The electrode assembly and the electrolyte react electrochemically to store and release (e.g., generate) energy. Terminal parts 11 and 12 electrically connected to the connection tab 20 and a vent 13 as a discharge passage for gas generated inside the battery case may be provided on one side of (e.g., an upper side of) the battery cell 10. The terminal parts 11 and 12 of the battery cell 10 may be a positive electrode terminal 21 and a negative electrode terminal 22 having different polarities from each other, and the terminal parts 11 and 12 of the adjacent battery cells 10a and 10b may be electrically connected to each other in series or parallel by the connection tab 20, to be described in more detail below. Although a serial connection has been described as an example, the connection structure is not limited thereto, and various connection structures may be employed as desired or necessary. In addition, the number and arrangement of battery cells is not limited to the structure shown in FIG. 3 and may be changed as desired or necessary.

The plurality of battery cells 10 may be arranged in (e.g., may be stacked in) one direction so that the wide surfaces of the battery cells 10 face each other, and the plurality of battery cells 10 may be fixed by the housings 61, 62, 63, and 64. The housings 61, 62, 63, and 64 may include a pair of end plates 61 and 62 facing the wide surfaces of the battery cell 10 and a side plate 63 and a bottom plate 64 connecting the pair of end plates 61 and 62 to each other. The side plate 63 may support side surfaces of the battery cells 10, and the bottom plate 64 may support bottom surfaces of the battery cells 10. In addition, the pair of end plates 61 and 62, the side plate 63 and the bottom plate 64 may be connected by bolts 65 and/or any other suitable fastening members and methods known to those of ordinary skill in the art.

The protection circuit module 30 may have electronic components and protection circuits mounted thereon and may be electrically connected to connection tabs 20, to be described in more detail later. The protection circuit module 30 includes a first protection circuit module 30a and a second protection circuit module 30b extending along the direction in which the plurality of battery cells 100 are arranged in different locations. The first protection circuit module 30a and the second protection circuit module 30b may be spaced from each other at a suitable interval (e.g., a predetermined interval) and arranged parallel to each other to be electrically connected to adjacent connection tabs 20, respectively. For example, the first protection circuit module 30a extends on one side of the upper portion of the plurality of battery cells 10 along the direction in which the plurality of battery cells 10 are arranged, and the second protection circuit module 30b extends to the other upper side of the plurality of battery cells 10 along the direction in which the plurality of battery cells 10 are arranged. The second protection circuit module 30b may be spaced from the first protection circuit module 30a at a suitable interval (e.g., a predetermined interval) with the vents 34 interposed therebetween but may be disposed parallel to the first protection circuit module 30a. As such, the two protection circuit modules are spaced from each other side-by-side along the direction in which the plurality of battery cells 10 are arranged, thereby reducing or minimizing the area of the printed circuit board (PCB) constituting the protection circuit module. By separately configuring the protection circuit module into two protection circuit modules, unnecessary PCM area can be reduced or minimized. In addition, the first protection circuit module 30a and the second protection circuit module 30b may be connected to each other by a conductive connection member 50. One side of the conductive connection member 50 is connected to the first protection circuit module 30a, and the other side thereof is connected to the second protection circuit module 30b so that the two protection circuit modules 30a and 30b can be electrically connected with each other.

The connection may be performed by any one of soldering, resistance welding, laser welding, projection welding and/or any other suitable connection methods known to those of ordinary skill in the art.

In addition, the connection member 50 may be, for example, an electric wire. In addition, the connection member 50 may be made of a material having elasticity or flexibility. By the connecting member 50, it may be possible to check and manage whether the voltage, temperature, and/or current of the plurality of battery cells 10 are normal. For example, the information received by the first protection circuit module from connection tabs adjacent to the first protection circuit module, such as voltage, current, and/or temperature, and the information received from connection tabs adjacent to the second protection circuit module, such as voltage, current, and/or temperature, may be integrated and managed by the protection circuit module through the connection member 50.

In addition, when the battery cell 10 swells, shocks may be absorbed by the elasticity or flexibility of the connection member 50, thereby preventing the first and second protection circuit modules 30a and 30b from being damaged.

In addition, the shape and structure of the connection member 50 is not limited to the shape and structure shown in FIG. 3.

As described above, because the protection circuit module 30 is provided as the first and second protection circuit modules 30a and 30b, the area of the PCB constituting the protection circuit module can be reduced or minimized, and the space inside the battery module can be secured, which improves work efficiency by facilitating a fastening work for connecting the connection tab 20 and the protection circuit module 30 and repair work if (or when) an abnormality is detected in the battery module.

### [Battery Pack]

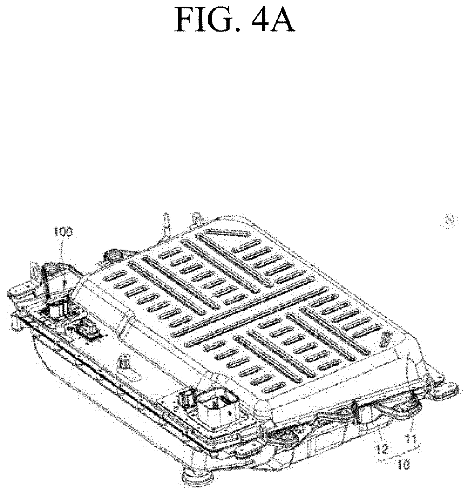

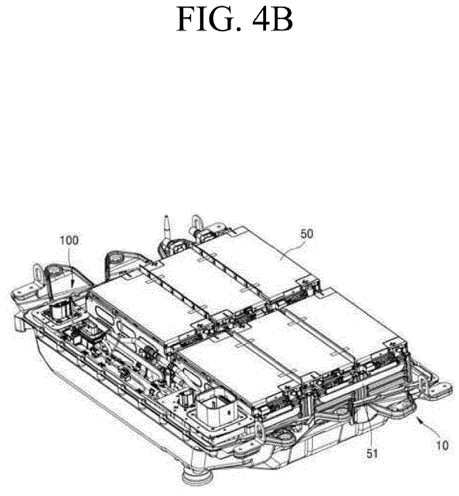

FIG. 4A and 4B are example views illustrating a battery pack according to one example embodiment of the present disclosure (in FIGS. 4A and 4B, the same reference symbols as other drawings may be shown, but usage of the reference symbols shown in FIGS. 4A and 4B is exclusive to FIGS. 4A and 4B).

The battery pack may include a plurality of battery modules 50 and a housing 10 for accommodating the plurality of battery modules 50. For example, the housing 10 may include first and second housings 11 and 12 coupled in opposite directions through the plurality of battery modules 50. The plurality of battery modules 50 may be electrically connected to each other by using a bus bar 51, and the plurality of battery modules 50 may be electrically connected to each other in a series/parallel or series-parallel mixed method, thereby obtaining desired (e.g., required) electrical output.

### [Vehicle body and vehicle body parts]

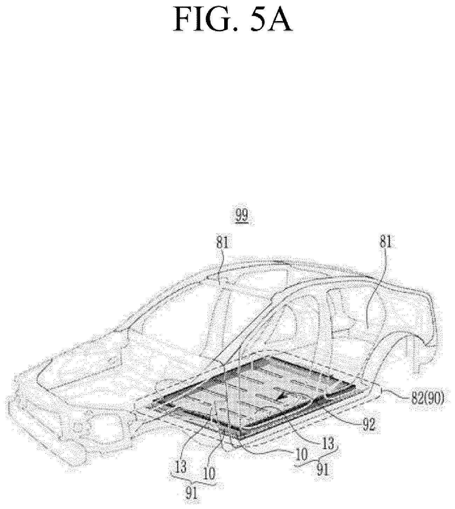

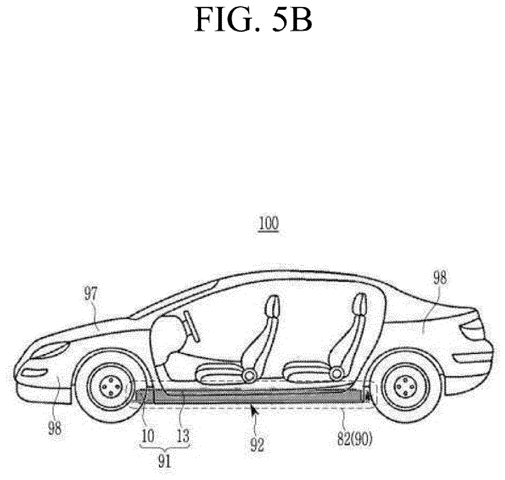

FIGS. 5A and 5B are example views illustrating a vehicle body including a battery pack and vehicle body parts according to one example embodiment of the present disclosure (in FIGS. 5A and 5B, the same reference symbols as other drawings may be shown, but usage of the reference symbols shown in FIGS. 5A and 5B is exclusive to FIGS. 5A and 5B).

In FIG. 5A, a battery pack 91 may include a battery pack cover 13, which is a part of a vehicle underbody 92, and a pack frame 10 disposed under the vehicle underbody 92. The pack frame 10 and the battery pack cover 13 may be integrally formed with a vehicle floor 82. The vehicle underbody 92 separates the inside and outside of a vehicle, and the pack frame 10 may be disposed outside the vehicle.

FIG. 5B is a schematic side view of a vehicle according to one or more embodiments of the present disclosure. A vehicle 100 may be formed by combining additional parts, such as a hood 97 in front of the vehicle and fenders 98 respectively located in the front and rear of the vehicle to a vehicle body 99. The vehicle 100 may further include a vehicle floor 82, which is one of the vehicle body parts 90 including the battery pack 91 including the pack frame 10 and the battery pack cover 13.

Hereinafter, based on such a battery structure, a specific method by which an internal resistance is calculated in the present embodiment will be described, focusing on an operation of a processor 100.

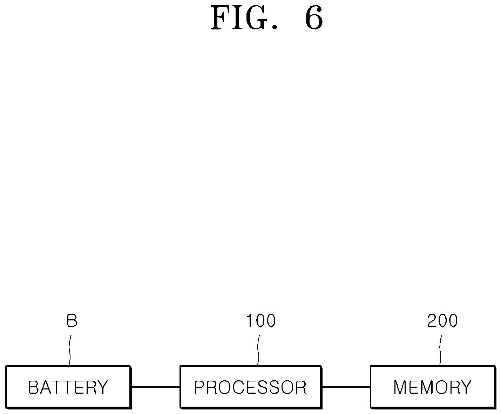

FIG. 6 is a block diagram of an apparatus for calculating an internal resistance of a battery according to one embodiment of the present disclosure. Referring to FIG. 6, an apparatus for calculating an internal resistance of a battery according to the present embodiment may include a processor 100 and a memory 200 (in FIG. 6, the same reference symbols as other drawings may be shown, but usage of the reference symbols shown in FIG. 6 is exclusive to FIG. 6).

The processor 100 may be implemented as a central processing unit (CPU) or a system-on-chip (SoC), may drive an operating system or application to control a plurality of hardware or software components connected to the processor 100, and may process various pieces of data and perform calculations. The processor 100 may be configured to execute at least one instruction stored in the memory 200 to be described below and store execution result data in the memory 200.

In the present embodiment, the processor 100 may operate to calculate an internal resistance of a battery B (that is, a battery cell) mounted on a vehicle. Specifically, the processor 100 may collect a current parameter and a voltage parameter of the battery when a data collection condition, which is predefined based on the discharge current characteristics of the battery in a driving state of the vehicle, is satisfied and may calculate the internal resistance of a battery cell based on the collected current parameter and voltage parameter. The processor 100 may be implemented as a battery management system (BMS) that collects a voltage, a current, a temperature, a state of charge (SOC), and state of a health (SOH) of a battery pack, a battery module, or a battery cell and performs battery charge/discharge control, monitoring and management, and cell balancing based on the collected data or may be implemented as a microcontroller unit (MCU) in the BMS. The specific operation of the processor 100 will be divided into a first embodiment and a second embodiment in the following description.

The memory 200 may store at least one instruction executed by the processor 100. The memory 200 may be implemented as a volatile storage medium and/or a non-volatile storage medium, for example, as a read-only memory (ROM) and/or a random access memory (RAM).

The operation of the processor 100 for calculating an internal resistance of a battery cell will be divided into the first embodiment and the second embodiment in the following detailed description based on the above content.

### 1. First embodiment: Actual driving state of vehicle

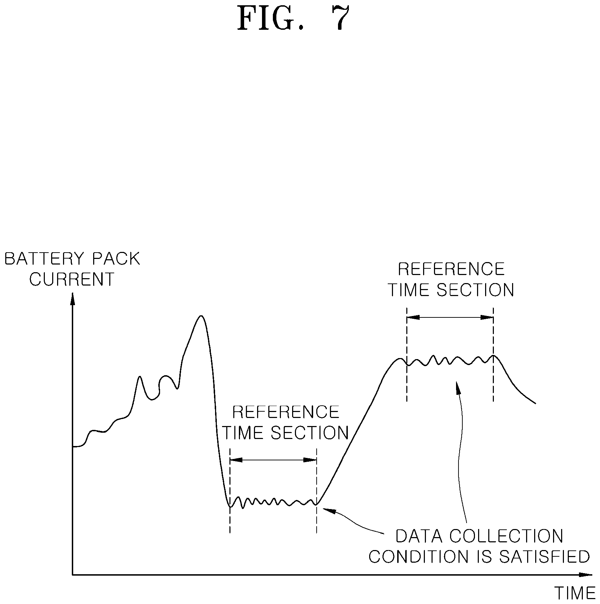

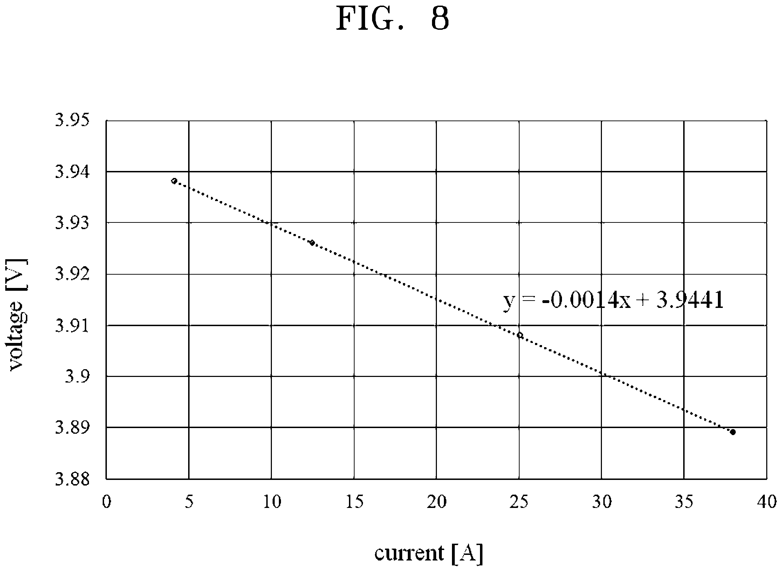

FIG. 7 shows an example of a data collection condition in the apparatus for calculating an internal resistance of a battery according to one embodiment of the present disclosure. FIGS. 8 to 10 show a process for calculating an internal resistance in the apparatus for calculating an internal resistance of a battery according to one embodiment of the present disclosure.

As described above, the processor 100 may collect a current parameter and a voltage parameter of a battery when a data collection condition, which is predefined based on the discharge current characteristics of the battery in a driving state of a vehicle, is satisfied and may calculate an internal resistance of a battery cell based on the collected current parameter and voltage parameter.

In the first embodiment, the driving state of the vehicle may correspond to an actual driving state of the vehicle (for example, a state in which the vehicle is actually driving on a road) (whether the vehicle is in the actual driving condition may be determined, for example, through a vehicle speed sensor or Global Positioning System (GPS) module mounted on the vehicle). That is, in the first embodiment, the processor 100 may operate to calculate the internal resistance of the battery cell based on a current parameter and a current parameter collected in the actual driving state of the vehicle in a state in which the battery is mounted on the vehicle. In addition, in the first embodiment, the current parameter of the battery may correspond to a discharge current of a battery pack, and the voltage parameter of the battery may correspond to a voltage of the battery cell. The collection of the discharge current of the battery pack and the voltage of the battery cell may be supported by a battery monitoring function of the processor 100 implemented as a BMS.

In addition, in the first embodiment, as shown in FIG. 7, a data collection condition serving as a start condition for calculating the internal resistance of the battery cell may be defined as a condition that a rate of change in discharge current of the battery pack is less than or equal to a preset threshold value during a preset reference time section in the actual driving state of the vehicle. That is, in order to simulate a constant current discharge environment that is generally applied when an internal resistance of a single cell of the battery is measured, the processor 100 may capture a state in which an amount of change in discharge current of the battery pack is small in the actual driving state of the vehicle. The reference time section and the threshold value adopted as references for determining "a state in which the change in the discharge current of the battery pack is small" may be preset in the processor 100 based on the designer's intention and experimental results (for example, reference value: 10 sec and threshold value: 0.3 A/sec). For a clear distinction between terms, the data collection condition applied in the first embodiment is referred to as a first data collection condition.

When the first data collection condition is satisfied, and thus a discharge current of the battery pack and a cell voltage of the battery cell are collected in the reference time section, the processor 100 may acquire an average value of the discharge current and an average value of the cell voltage in the reference time section and may calculate the internal resistance of the battery cell based on the acquired average value of the discharge current and the acquired average value of the cell voltage. For example, the processor 100 may calculate the internal resistance of the battery cell through a calculation method of dividing the average value of the cell voltage by the average value of the discharge current.

As described above, the internal resistance of the battery cell may be calculated through the calculation method of dividing the average value of the cell voltage by the average value of the discharge current. However, since an inherent error of an "average value" adopted as a factor in a process of calculating the internal resistance of the battery cell may cause an error in a calculated value of the internal resistance of the battery cell, in the present embodiment, the processor 100 may calculate the internal resistance of the battery pack through a method of acquiring an average value of a discharge current of the battery pack and an average value of a cell voltage of the battery cell in a plurality of time sections and interpolating the average values in the plurality of time sections, thereby compensating for an error of the internal resistance of the battery cell calculated in a single time section.

Specifically, first, the processor 100 may obtain a first average value of a discharge current of the battery and a first average value of a cell voltage of the battery in the first reference time section in which the first data collection condition is satisfied. The processor 100 may obtain a second average value of a discharge current of the battery and a second average value of a cell voltage of the battery in a second reference time section in which the first data collection condition is subsequently satisfied after the first reference time section.

Subsequently, the processor 100 may calculate the internal resistance of the battery cell through a method of interpolating the first average value of the discharge current, the first average value of the cell voltage, the second average value of the discharge current, and the second average value of the cell voltage. As such an interpolation method, a linearization method, in which a straight line is used to connect a point (hereinafter referred to as a first point) defined by the first average value of the discharge current and the first average value of the cell voltage to a point (hereinafter referred to as a second point) defined by the second average values of the discharge current and the second average value of the cell voltage, may be applied. Accordingly, the processor 100 may calculate a slope (absolute value of the slope) of the straight line between the first point and the second point in a coordinate system, in which a horizontal axis and a vertical axis represent a current (battery pack current) and a voltage (battery cell voltage), respectively, as the internal resistance of the battery cell.

Above, an embodiment has been described in which the internal resistance of the battery cell is calculated in at least two reference time sections required to compensate for an error of the internal resistance of the battery cell calculated in a single time section. However, accuracy in calculating a resistance of the battery cell may increase as the number of reference time sections for which an average value of a discharge current and an average value of a cell voltage are acquired increases, and thus the processor 100 calculates an internal resistance of the battery cell in consideration of an average value of a discharge current and an average value of a cell voltage obtained for a total of four reference time sections as shown in FIG. 8, thereby improving accuracy in calculating the internal resistance.

Meanwhile, the processor 100 may calculate an internal resistance of the battery cell for each SOC of the battery pack and may derive a change in internal resistance according to the SOC of the battery pack. In parallel therewith, the processor 100 may calculate an internal resistance of the battery cell for each discharge rate (discharge C-rate) of the battery pack and may derive a change in internal resistance according to the discharge rate of the battery pack (such an operation is based on a state in which the SOC and the discharge rate of the battery pack have different values according to a time point at which the internal resistance of the battery cell is calculated). Collection of the SOC and the discharge rate of the battery pack may be supported by a battery monitoring function of the processor 100 implemented as a BMS.

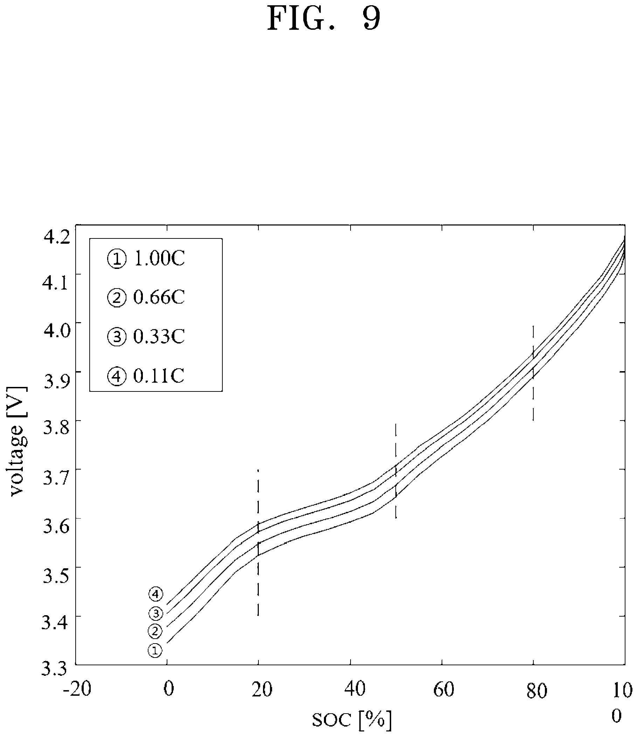

In order to calculate the internal resistance of the battery cell for each SOC and each discharge rate of the battery pack, as shown as an example in Table 1 below, the processor 100 may first collect a battery cell voltage according to an SOC and a discharge rate of the battery pack. FIG. 9 is a graph showing collection results in Table 1.

**[Table 1]**

| | | SOC | | |
|---|---|---|---|---|
| | | 20% | 50% | 80% |
| Discharge rate (C-rate) | 0.11 C | 3.59 V | 3.72 V | 3.94 V |
| | 0.33 C | 3.57 V | 3.69 V | 3.93 V |
| | 0.66 C | 3.55 V | 3.66 V | 3.91 V |
| | 1.00 C | 3.52 V | 3.64 V | 3.89 V |

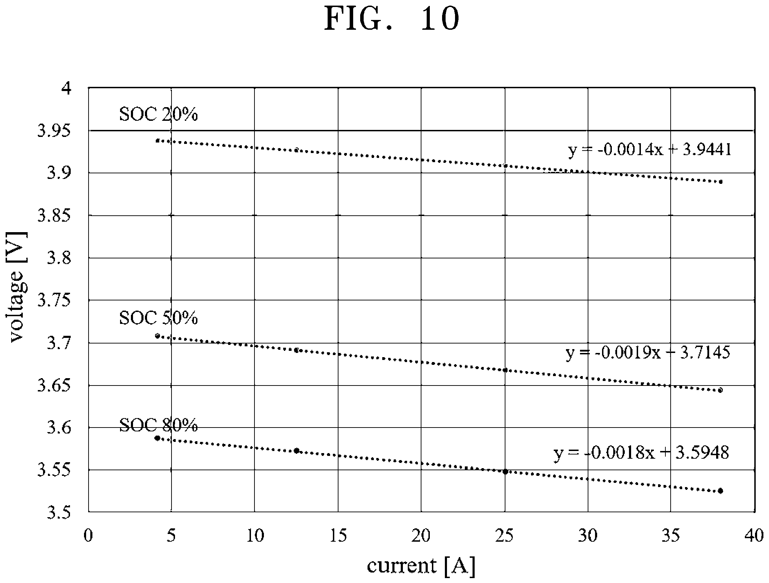

Based on the data in Table 1, the processor 100 may calculate the internal resistance of the battery cell for each SOC of the battery pack. That is, the processor 100 may calculate the internal resistance of the battery cell for each SOC of the battery pack through a process of repeatedly performing a process of calculating a slope of a straight line according to the above-described interpolation method for each SOC. FIG. 10 shows an example in which, when the SOCs of the battery pack are respectively 20%, 50%, and 80%, the internal resistances of the battery cell are calculated to be 0.0018, 0.0019, and 0.0014, respectively. Thereafter, the processor 100 may derive a change in internal resistance according to the SOC of the battery pack (for example, relationship data between a change in SOC of the battery pack and a change in internal resistance of the battery cell) and may store the derived change in internal resistance in the memory 200. The relationship data stored in 200 may be used to predict and manage the lifespan of the battery pack later.

Likewise, the processor may calculate the internal resistance of the battery cell for each discharge rate of the battery pack based on the data in Table 1. That is, the processor 100 may calculate the internal resistance of the battery cell for each discharge rate of the battery pack through a process of repeatedly performing a process of calculating a slope of a straight line according to the above-described interpolation method for each discharge rate. Thereafter, the processor 100 may derive a change in internal resistance according to the discharge rate of the battery pack (for example, relationship data between a change in discharge of the battery pack and a change in internal resistance of the battery cell) and may store the derived change in internal resistance in the memory 200. The relationship data stored in 200 may be used to predict and manage the lifespan of the battery pack later.

### 2. Second embodiment: Driving simulation state of vehicle

The above-described first embodiment focuses on a configuration for starting a calculation operation of an internal resistance of the battery cell when the first data collection condition that the rate of change in discharge current of the battery pack is less than or equal to the preset threshold value during the preset reference time section in the actual driving state of the vehicle is satisfied. However, according to an actual driving environment of the vehicle, a case in which the above first data collection condition is satisfied may not occur for a long time (for example, a case in which the first data collection condition is satisfied may not occur for a preset time (for example, 72 hours)).

In order to calculate an internal resistance of the battery cell installed on the vehicle in such a situation, the second embodiment presents a configuration for calculating the internal resistance of the battery cell in a driving simulation state rather than an actual driving state of the vehicle. That is, the second embodiment functions as a redundancy logic of the first embodiment. The driving simulation state of the vehicle may correspond, for example, to a state in which only a motor (driving motor) of the vehicle is driven without the actual driving of the vehicle in a state in which the vehicle is positioned on a chassis dynamometer, and it is based on assuming that the vehicle is positioned in a specific space (for example, a vehicle repair shop) in which the chassis dynamometer is installed.

Unlike the actual driving state of the vehicle, in the driving simulation state, since the battery pack may be controlled to be discharged at a constant current, in the second embodiment, a data collection condition is not defined according to a rate of change in discharge current of the battery pack, but is defined as a condition that constant current discharging of the battery pack is performed. Accordingly, when constant current discharging of the battery pack is performed in the driving simulation state of the vehicle, the processor 100 may determine that the data collection condition is satisfied. For a clear distinction between terms, the data collection condition applied in the second embodiment is referred to as a second data collection condition.

When the second data collection condition is satisfied, the processor 100 may collect a discharge constant current of the battery pack and a cell voltage of the battery as a current parameter and a voltage parameter of the battery and may calculate an internal resistance of the battery cell based on the collected discharge constant current and cell voltage. For example, the processor 100 may calculate the internal resistance of the battery cell through a calculation method of dividing the cell voltage by the discharge current.

As described above, the internal resistance of the battery cell may be calculated through the calculation method of dividing the cell voltage by the discharge current. However, as in the first embodiment, in order to improve accuracy in calculating the internal resistance of the battery cell, the processor 100 may acquire a discharge current of the battery pack and a cell voltage of the battery cell at a plurality of time points and may calculate an internal resistance of the battery cell through a method of interpolating a discharge current and a cell voltage for each of the plurality of time points, thereby compensating for an error of the internal resistance of the battery cell calculated for a single time point.

Specifically, the processor 100 may collect a first value of a discharge constant current of the battery and a first value of a cell voltage of the battery at a first reference time point at which the second data collection condition is satisfied. The processor 100 may collect a second value of a discharge constant current of the battery and a second value of a cell voltage of the battery at a second reference time at which the second data collection condition is subsequently satisfied after the first reference time.

Subsequently, the processor 100 may calculate the internal resistance of the battery cell through a method of interpolating the collected first value of the discharge constant current, the collected first value of the cell voltage, the collected second value of the discharge constant current, and the collected second value of the cell voltage. As such an interpolation method, a linearization method, in which a straight line is used to connect a point defined by the first value of the discharge constant current and the first value of the cell voltage (hereinafter referred to as a first point which is distinguished from the first point defined in the first embodiment) to a point defined by the second value of the discharge constant current and the second average value of the cell voltage (hereinafter referred to as a second point which is distinguished from the second point defined in the first embodiment), may be applied. Accordingly, the processor 100 may calculate a slope (absolute value of the slope) of the straight line between the first point and the second point in a coordinate system in which a horizontal axis and a vertical axis represent a current (battery pack current) and a voltage (battery cell voltage), respectively, as the internal resistance of the battery cell. Similar to the first embodiment, the processor 100 calculates an internal resistance of the battery cell in consideration of discharge constant current values and cell voltage values obtained for three or more time points, thereby improving accuracy in calculating the internal resistance.

Meanwhile, the processor 100 may calculate the internal resistance of the battery cell for each SOC of the battery pack and derive a change in internal resistance according to the SOC of the battery pack. In parallel therewith, the processor 100 may calculate the internal resistance of the battery cell according to a discharge rate (discharge C-rate) of the battery pack and derive a change in internal resistance according to the discharge rate of the battery pack (such an operation is based on a state in which the SOC and the discharge rate of the battery pack have different values according to a time point at which the internal resistance of the battery cell is calculated). Collection of the SOC and the discharge rate of the battery pack may be supported by the battery monitoring function of the processor 100 implemented as a BMS. Such a configuration is the same as the first embodiment, and thus a detailed description thereof will be omitted.

### 3. Method of calculating internal resistance of battery

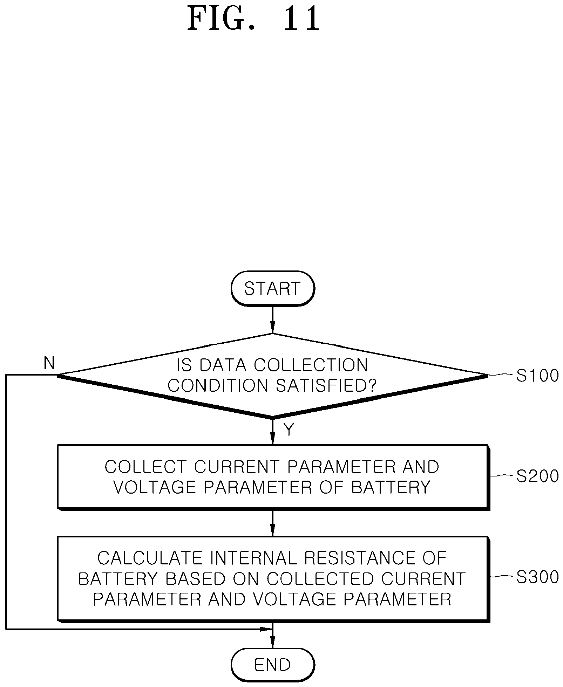

FIGS. 11 to 13 are a flowchart of a method of calculating an internal resistance of a battery according to one embodiment of the present disclosure. The method of calculating an internal resistance of a battery performed by the processor 100 will be described with reference to FIGS. 11 to 13. Detailed description of content that overlaps the above-described content will be omitted, and the description will focus on a time-series configuration.

First, referring to FIG. 11, the method of calculating an internal resistance of a battery of the present embodiment may include operation S100 of determining whether a data collection condition, which is predefined based on the discharge current characteristics of a battery in a driving state of a vehicle, is satisfied, operation S200 of, when the data collection condition is satisfied, collecting a current parameter and a voltage parameter of the battery, and operation S300 of calculating an internal resistance of the battery based on the current parameter and voltage parameter collected in operation S200. Operation S100 includes operations S110 and S120 described below, operation S200 includes operations S210 to S230 described below, and operation S300 includes operations S310 to S330.

In operations S100 to S300, the processor 100 operates differentially according to whether "a condition that a rate of change in discharge current of the battery is less than or equal to a preset threshold value during a preset reference time section in an actual driving state of the vehicle" is satisfied. That is, when the first data collection condition is satisfied, the internal resistance of the battery cell is calculated according to the first embodiment described above. When the first data collection condition is not satisfied, the internal resistance of the battery cell is calculated according to the second embodiment which serves as a redundancy logic of the first embodiment. A time-series configuration in which the first or second embodiment is performed according to whether the first data collection condition is satisfied will be described below.

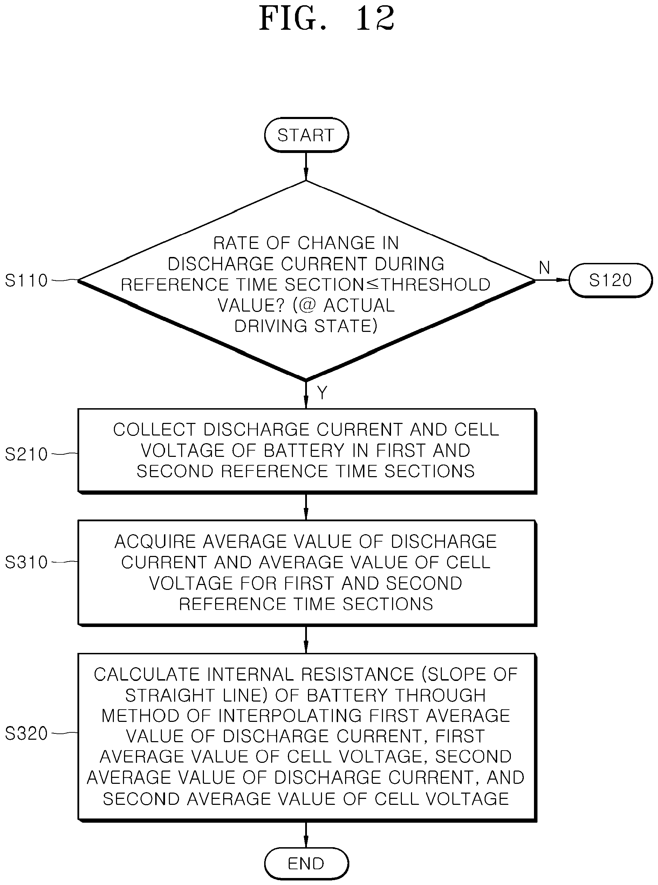

Referring to FIG. 12, the processor 100 preferentially determines whether the rate of change in discharge current of the battery is less than or equal to the preset threshold value during the preset reference time section in the actual driving state of the vehicle (S110). That is, the processor 100 preferentially determines whether the first data collection condition is satisfied.

When it is determined in operation S110 that the first data collection condition is satisfied, the processor 100 collects a discharge current and a cell voltage of the battery as a current parameter and a voltage parameter of the battery in the first and second time sections in which the first data collection condition is satisfied (S210).

Subsequently, the processor 100 acquires a first average value of the discharge current of the battery and a first average value of the cell voltage of the battery in the first reference time section and acquires a second average value of the discharge current of the battery and a second average value of the cell voltage of the battery cell in the second reference time section (S310). Then, the processor 100 calculates the internal resistance of the battery through a method of interpolating the first average value of the discharge current, the first average value of the cell voltage, the second average value of the discharge current, and the second average value of the cell voltage (S320). In this case, the processor 100 may calculate a slope of a straight line, which connects a point defined by the first average value of the discharge current and the first average value of the cell voltage and a point defined by the second average value of the discharge current and the second average value of the cell voltage, as the internal resistance of the battery.

Meanwhile, when the internal resistance of the battery is calculated for each SOC of the battery as operations S110, S210, S310, and S320 are repeatedly performed, the processor 100 may operate to derive a change in internal resistance according to the SOC of the battery and store the derived change in internal resistance in a memory 200. Meanwhile, when the internal resistance of the battery is calculated for each discharge rate of the battery as operations S110, S210, S310, and S320 are repeatedly performed, the processor 100 may operate to derive a change in internal resistance according to the discharge rate of the battery and store the derived change in internal resistance in the memory 200.

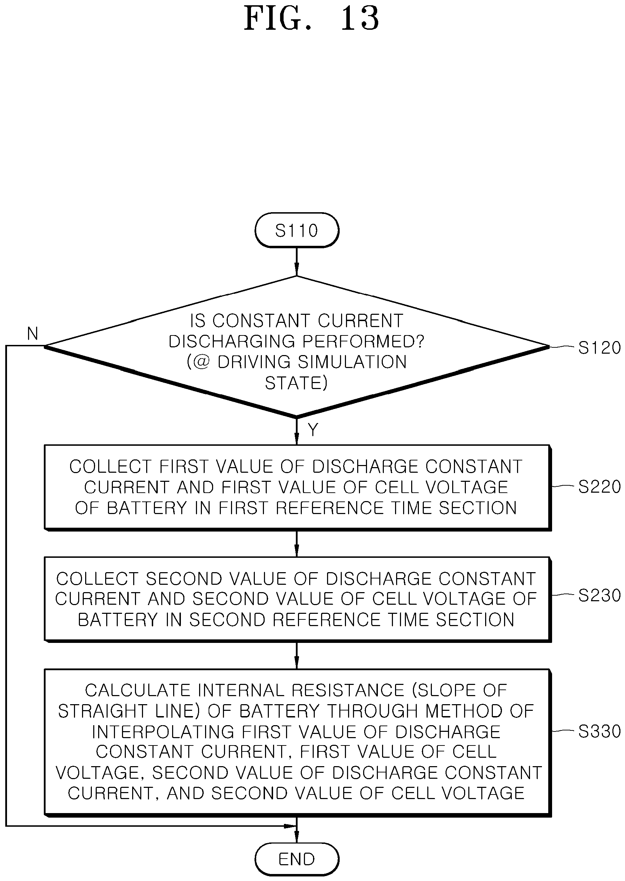

Next, referring to FIG. 13, when it is determined in operation S110 that the first data collection condition is not satisfied, the processor 100 determines whether constant current discharging of the battery is performed in a driving simulation state of the vehicle (S120). That is, when the first data collection condition is not satisfied, the processor 100 determines whether a second data collection condition, which serves as a condition for calculating the internal resistance of the battery according to a redundancy logic of the first data collection condition being not satisfied, is satisfied.

When it is determined in operation S120 that the second data collection condition is satisfied, the processor 100 collects a discharge current and a cell voltage of the battery as a current parameter and a voltage parameter of the battery at the first and second reference time points at which the second data collection condition is satisfied (S220 and S230). That is, the processor 100 collects a first value of a discharge constant current and a first value of a cell voltage of the battery at the first reference time point at which the second data collection condition is satisfied (S220) and collects a second value of a discharge constant current and a second value of a cell voltage of the battery at the second reference time point at which the second data collection condition is satisfied after the first reference time point (S230).

Subsequently, the processor 100 may calculate the internal resistance of the battery cell through a method of interpolating the first value of the discharge constant current, the first value of the cell voltage, the second value of the discharge constant current, and the second value of the cell voltage (S330). In this case, the processor 100 may calculate a slope of a straight line, which connects a point defined by the first value of the discharge constant current and the first value of the cell voltage and a point defined by the second value of the discharge constant current and the second value of the cell voltage, as the internal resistance of the battery.

Meanwhile, when the internal resistance of the battery is calculated for each SOC of the battery as operations S120, S220, S230, and S330 are repeatedly performed, the processor 100 may operate to derive a change in internal resistance according to the SOC of the battery and store the derived change in internal resistance in the memory 200. In order to differentially form an SOC of the battery, the processor 100 may form a plurality of SOCs through a method of calculating a battery charging target current for satisfying a plurality of SOCs input by an operator, and performing feedback control for allowing a currently input current of a battery pack to follow the battery charging target current. Similarly, when the internal resistance of the battery is calculated for each discharge rate of the battery as operations S120, S220, S230, and S330 are repeatedly performed, the processor 100 may operate to derive a change in internal resistance according to the discharge rate of the battery and store the derived change in internal resistance in a memory 200.

The method of calculating an internal resistance of a battery according to the present embodiment can be implemented as a computer program for executing operations S100 to S300 described above in combination with hardware and can be stored in a computer-readable recording medium and implemented in a general-purpose digital computer that operates the computer program. The computer-readable recording medium may correspond to a ROM, a RAM, a magnetic medium such as a hard disk, a floppy disk, or magnetic tape, an optical medium a such as a compact disc (CD)-ROM or a digital video disc (DVD), a magneto-optical medium such as a floptical disk, or a hardware device specially configured to store and execute program instructions such as a flash memory.

In this way, according to the present disclosure, when a predefined data collection condition is satisfied based on the discharge current characteristics of a battery in a driving state of a vehicle, by adopting a method of calculating an internal resistance of a battery based on a current parameter and a voltage parameter of a battery, even in a state in which a battery is mounted on the vehicle, the internal resistance of a battery cell can be measured without the separation or removal of the battery from the vehicle.

However, effects that can be achieved through the present disclosure are not limited to the above-described effects and other effects that are not described may be clearly understood by those skilled in the art from the detailed descriptions.

Herein, the embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims and their equivalents, below.

Further Embodiments are set out in the following clauses:
Clause 1. An apparatus for calculating an internal resistance of a battery, the apparatus comprising:
   a processor configured to calculate an internal resistance of a battery mounted on a vehicle; and
   a memory configured to store instructions executed by the processor,
   wherein, when a data collection condition, which is predefined based on discharge current characteristics of the battery in a driving state of the vehicle, is satisfied, the processor collects a current parameter and a voltage parameter of the battery and calculates the internal resistance of the battery based on the collected current parameter and voltage parameter.
Clause 2. The apparatus of clause 1, wherein the data collection condition is a condition that a rate of change in discharge current of the battery is less than or equal to a preset threshold value during a reference time section preset in an actual driving state of the vehicle.
Clause 3. The apparatus of clause 2, wherein the processor collects a discharge current and a cell voltage of the battery as the current parameter and the voltage parameter in the reference time section in which the data collection condition is satisfied, and collects the internal resistance of the battery based on the collected discharge current and cell voltage.
Clause 4. The apparatus of clause 3, wherein the processor acquires an average value of the discharge current and an average value of the cell voltage in the reference time section and calculates the internal resistance of the battery based on the acquired average value of the discharge current and the acquired average value of the cell voltage.
Clause 5. The apparatus of clause 4, wherein the processor acquires a first average value of the discharge current of the battery and a first average value of the cell voltage of the battery in a first reference time section in which the data collection condition is satisfied, acquires a second average value of the discharge current of the battery and a second average value of the cell voltage of the battery in a second reference time section in which the data collection condition is satisfied after the first reference time section, and calculates the internal resistance of the battery through a method of interpolating the first average value of the discharge current, the first average value of the cell voltage, the second average value of the discharge current, and the second average value of the cell voltage.
Clause 6. The apparatus of clause 5, wherein the processor calculates a slope of a straight line, which connects a point defined by the first average value of the discharge current and the first average value of the cell voltage and a point defined by the second average value of the discharge current and the second average value of the cell voltage, as the internal resistance of the battery.
Clause 7. The apparatus of clause 1, wherein the data collection condition is a condition that constant current discharging of the battery is performed in a driving simulation state of the vehicle.
Clause 8. The apparatus of clause 7, wherein, when the data collection condition is satisfied, the processor collects a discharge constant current and a cell voltage of the battery as the current parameter and the voltage parameter and calculates the internal resistance of the battery based on the collected discharge constant current and cell voltage.
Clause 9. The apparatus of clause 8, wherein the processor collects a first value of the discharge constant current and a first value of the cell voltage of the battery at a first reference time point at which the data collection condition is satisfied, collects a second value of the discharge constant current and a second value of the cell voltage of the battery at a second reference time point at which the data collection condition is satisfied after the first reference time, and calculates the internal resistance of the battery through a method of interpolating the first value of the discharge constant current, the first value of the cell voltage, the second value of the discharge constant current, and the second value of the cell voltage.
Clause 10. The apparatus of clause 9, wherein the processor calculates a slope of a straight line, which connects a point defined by the first value of the discharge constant current and the first value of the cell voltage and a point defined by the second value of the discharge constant current and the second value of the cell voltage, as the internal resistance of the battery.
Clause 11. The apparatus of any preceding clause, wherein the processor calculates the internal resistance of the battery for each state of charge (SOC) of the battery and derives a change in internal resistance according to the SOC of the battery.
Clause 12. The apparatus of any preceding clause, wherein the processor calculates the internal resistance of the battery for each discharge rate of the battery and derives a change in internal resistance according to the discharge rate of the battery.
Clause 13. A method of calculating an internal resistance of a battery mounted on a vehicle, the method comprising:
   determining, by a processor, whether a data collection condition, which is predefined based on discharge current characteristics of the battery in a driving state of the vehicle, is satisfied;
   when the data collection condition is satisfied, collecting, by the processor, a current parameter and a voltage parameter of the battery; and
   calculating, by the processor, the internal resistance of the battery based on the collected current parameter and voltage parameter.
Clause 14. The method of clause 13, wherein, in the determining, when a rate of change in discharge current of the battery is less than or equal to a preset threshold value during a reference time section preset in an actual driving state of the vehicle, the processor determines that the data collection condition is satisfied.
Clause 15. The method of clause 14, wherein, in the collecting, in a first reference time section in which the data collection condition is satisfied and in a second reference time section in which the data collection condition is satisfied after the first reference time section, the processor collects a discharge current and a cell voltage of the battery as the current parameter and the voltage parameter, and
   wherein, in the calculating, the processor acquires a first average value of the discharge current of the battery and a first average value of the cell voltage of the battery in the first reference time section, acquires a second average value of the discharge current of the battery and a second average value of the cell voltage of the battery in the second reference time section, and calculates the internal resistance of the battery through a method of interpolating the first average value of the discharge current, the first average value of the cell voltage, the second average value of the discharge current, and the second average value of the cell voltage.

## Claims

1. An apparatus for calculating an internal resistance of a battery, the apparatus comprising:
a processor configured to calculate an internal resistance of a battery mounted on a vehicle; and
a memory configured to store instructions executed by the processor,
wherein, when a data collection condition, which is predefined based on discharge current characteristics of the battery in a driving state of the vehicle, is satisfied, the processor is configured to collect a current parameter and a voltage parameter of the battery and to calculate the internal resistance of the battery based on the collected current parameter and voltage parameter.

2. The apparatus of claim 1, wherein the data collection condition is a condition that a rate of change in discharge current of the battery is less than or equal to a preset threshold value during a reference time section preset in an actual driving state of the vehicle.

3. The apparatus of claim 2, wherein the processor is configured to collect a discharge current and a cell voltage of the battery as the current parameter and the voltage parameter in the reference time section in which the data collection condition is satisfied, and to collect the internal resistance of the battery based on the collected discharge current and cell voltage.

4. The apparatus of claim 3, wherein the processor is configured to acquire an average value of the discharge current and an average value of the cell voltage in the reference time section and to calculate the internal resistance of the battery based on the acquired average value of the discharge current and the acquired average value of the cell voltage.

5. The apparatus of claim 4, wherein the processor is configured to acquire a first average value of the discharge current of the battery and a first average value of the cell voltage of the battery in a first reference time section in which the data collection condition is satisfied, is configured to acquire a second average value of the discharge current of the battery and a second average value of the cell voltage of the battery in a second reference time section in which the data collection condition is satisfied after the first reference time section, and is configured to calculate the internal resistance of the battery through a method of interpolating the first average value of the discharge current, the first average value of the cell voltage, the second average value of the discharge current, and the second average value of the cell voltage.

6. The apparatus of claim 5, wherein the processor is configured to calculate a slope of a straight line, which connects a point defined by the first average value of the discharge current and the first average value of the cell voltage and a point defined by the second average value of the discharge current and the second average value of the cell voltage, as the internal resistance of the battery.

7. The apparatus of claim 1, wherein the data collection condition is a condition that constant current discharging of the battery is performed in a driving simulation state of the vehicle.

8. The apparatus of claim 7, wherein, when the data collection condition is satisfied, the processor is configured to collect a discharge constant current and a cell voltage of the battery as the current parameter and the voltage parameter and is configured to calculate the internal resistance of the battery based on the collected discharge constant current and cell voltage.

9. The apparatus of claim 8, wherein the processor is configured to collect a first value of the discharge constant current and a first value of the cell voltage of the battery at a first reference time point at which the data collection condition is satisfied, is configured to collect a second value of the discharge constant current and a second value of the cell voltage of the battery at a second reference time point at which the data collection condition is satisfied after the first reference time, and is configured to calculate the internal resistance of the battery through a method of interpolating the first value of the discharge constant current, the first value of the cell voltage, the second value of the discharge constant current, and the second value of the cell voltage.

10. The apparatus of claim 9, wherein the processor is configured to calculate a slope of a straight line, which connects a point defined by the first value of the discharge constant current and the first value of the cell voltage and a point defined by the second value of the discharge constant current and the second value of the cell voltage, as the internal resistance of the battery.

11. The apparatus of any preceding claim, wherein the processor is configured to calculates the internal resistance of the battery for each state of charge (SOC) of the battery and to derive a change in internal resistance according to the SOC of the battery.

12. The apparatus of any preceding claim, wherein the processor is configured to calculate the internal resistance of the battery for each discharge rate of the battery and to derive a change in internal resistance according to the discharge rate of the battery.

13. A method of calculating an internal resistance of a battery mounted on a vehicle, the method comprising:
determining, by a processor, whether a data collection condition, which is predefined based on discharge current characteristics of the battery in a driving state of the vehicle, is satisfied;
when the data collection condition is satisfied, collecting, by the processor, a current parameter and a voltage parameter of the battery; and
calculating, by the processor, the internal resistance of the battery based on the collected current parameter and voltage parameter.

14. The method of claim 13, wherein, in the determining, when a rate of change in discharge current of the battery is less than or equal to a preset threshold value during a reference time section preset in an actual driving state of the vehicle, the processor determines that the data collection condition is satisfied.

15. The method of claim 14, wherein, in the collecting, in a first reference time section in which the data collection condition is satisfied and in a second reference time section in which the data collection condition is satisfied after the first reference time section, the processor collects a discharge current and a cell voltage of the battery as the current parameter and the voltage parameter, and
wherein, in the calculating, the processor acquires a first average value of the discharge current of the battery and a first average value of the cell voltage of the battery in the first reference time section, acquires a second average value of the discharge current of the battery and a second average value of the cell voltage of the battery in the second reference time section, and calculates the internal resistance of the battery through a method of interpolating the first average value of the discharge current, the first average value of the cell voltage, the second average value of the discharge current, and the second average value of the cell voltage.
